# EUROPEAN PATENT SPECIFICATION

(11) **EP 1 113 492 B1**
(45) Date of publication and mention of the grant of the patent: **23.09.2009**
(21) Application number: 99830826.6
(22) Date of filing: 31.12.1999
(51) Int. Cl.: H01L 21/762, H01L 21/316

(54) **Method for manufacturimg a SOI wafer**
Herstellungsverfahren eines SOI Wafers
Procédé de fabrication d'une plaquette SOI

(43) Date of publication of application: 04.07.2001
(73) Proprietor: STMicroelectronics S.r.l., 20041 Agrate Brianza (Milano) (IT)
(72) Inventor: D'Arrigo, Giuseppe, 95030 Tremestieri Etneo (CT) (IT); Spinella, Corrado, 95126 Catania (IT); Coffa, Salvatore, 95030 Tremestieri Etneo (CT) (IT); Arena, Giuseppe, 95125 Catania (IT); Camalleri, Marco, 95125 Catania (IT)
(74) Representative: Botti, Mario

(56) References cited:
- EP-A- 0 226 091
- WO-A-93/10559
- FR-A- 2 564 241
- US-A- 5 686 342

## Description

### Field of the Invention

This invention relates to a method of fabricating a SOI (Silicon-On-Insulator) wafer suitable to manufacture semiconductor electronic devices and comprising a substrate of monocrystalline silicon having a top surface, and a doped region buried in said substrate.

### Prior Art

As it is known, as an alternative to wafers made of only silicon, in recent years in the microelectronic industry have been proposed composite wafers, known as SOI wafers, which comprise at least two silicon layers, one of which being thinner than the other, and an isolation layer of silicon oxide therebetween. Reference can be made, for instance, to the article "Silicon-on-Insulator Wafer Bonding-Wafer Thinning Technological Evaluations" by J. Hausman, G. A. Spierings, U. K. P. Bierman and J. A. Pals, Japanese Journal of Applied Physics, Vol. 28, No. 8, August 1989, pages 1426-1443.

The Silicon-On-Insulator isolation technology has recently aroused considerable interest, because integrated circuits having a substrate formed of SOI wafers have several advantages over circuits realised on traditional substrates made of monocrystalline silicon only. These are the main advantages:
- parasitic capacitance reduction;
- switching speed increase;
- greater immunity to noise;
- less leakage currents;
- no latch-up of parasitic components;
- greater resistance to radiation effects;
- increase of the component packaging density.

However, the application of integrated devices based on SOI substrates is severely limited in particular by the high cost of SOI wafers.

As described in the above article, a typical method of manufacturing SOI wafers comprises bonding two wafers of monocrystalline silicon together. According to such process, one of the two wafers is subjected, to an oxidation step, which allows to form an oxide layer on one surface. The oxide layer surface is then cleaned and bonded to the other wafer. The SOI wafers thus obtained exhibit excellent electrical characteristics but are cost-intensive.

Another method, commonly known as SIMOX (Separation by IMplants of OXygen) method, comprises the implantation of oxygen atoms into the wafer to bring the oxide thickness into the 100 to 200 nm range.

This and other methods are described in an article "SOI Technologies: Their Past, Present and Future" by J. Haisha, Journal de Physique, Colloque C4, Supplement an N. 9, Tome 49, September 1988. Although these techniques produce the SOI structure using a single wafer, they have certain disadvantages, such as the inability to accept the application of high voltages, as in case of SIMOX technology, and the high faultiness rate due to crystallographic defects produced by the stress induced by the buried oxide.

It is also known a method of fabricating SOI wafers at a low cost, described in the European Patent No. 0957515 May 15, 1998, of the same Applicant. This method comprises the following steps:
- subjecting a substrate of monocrystalline silicon to a thermal oxidation step in order to grow a silicon oxide layer over its surface;
- removing certain oxide areas, whereinto ions with dopant opposite to the one of the substrate are implanted and diffused, in order to provide plural areas with dopant opposite to the one of the substrate, beneath the top surface of the substrate;
- growing an epitaxial layer with the same dopant and concentration of the substrate;
- subjecting again the semiconductor to a thermal oxidation step, and etching to define trench-like openings extending from the surface to the buried regions;
- dipping the wafer into an electrolytic solution in a galvanic cell, in which it is subjected to a selective electrochemical etching step of said areas having an opposite dopant to the one of the substrate, with porosity formation;
- subjecting the wafer to thermal oxidation, so that the porous regions are changed into oxidised regions;
- removing said oxidised regions to leave a buried cavity;
- proceeding with a new oxidation to fill the trench-like openings and said buried cavity with oxide.

Although in many ways advantageous, this method has a drawback in that the processing sequence above described is burdened with a large number of steps.

Furthermore, a fairly high rate of crystallographic defects is to be expected from such a sequence. Since the rate of thermal oxidation is not constant along all the walls of the structure and especially at the corners thereof, some of the trench-like openings will tend to close in advance, causing a wedging effect and consequent high stress, which will be relieved through the formation of crystallographic defects.

The French Patent Application No. 2564241 describes a manufacturing method for IC on SOI comprising the step of forming porous oxide layer starting from a stack structure that comprises a first n or p type layer, a n+ type layer and a second n or p type layer.

The European Patent Application No. 226091 describes a method of fabricating an island of semiconductor material comprising the step of forming a porous oxide layer starting from a stack structure that comprises a first n type layer, a n+ type layer and a second n type layer i.e. layers the same type of conductivity, but different concentrations.

The underlying technical problem of this invention is to provide with a low-cost method of fabricating SOI wafers showing a high yield, suitable to manufacture electronic devices monolithically integrated on a semiconductor.

### Summary of the Invention

The concept behind this invention is that one of turning the doped buried region, trapped within the substrate of monocrystalline silicon, into a region of porous oxide having electrical and physical properties similar to those of a thermal oxide.

Briefly stated, according to the invention the method comprises a step of forming trench-like openings extended from the substrate surface to the buried region; a selective etching step, to be carried out through said openings in order to turn said buried region of monocrystalline silicon into porous silicon; a step of oxidising of said porous silicon to produce an insulating portion of said SOI wafer.

Based on the above concept, the technical problem is solved by a method as previously indicated and defined by the characterising part of the here attached Claim 1.

The features and advantages of the method according to this invention can be appreciated from the following description of an embodiment thereof, given by way of illustration and not of limitation with reference to the accompanying drawings.

### Brief Description of the Drawings

Figures 1a-f schematically show an enlarged vertical cross-section viewof a portion of a semiconductor substrate, chronologically subjected to the various steps of the inventive method.
Figure 2a shows a SEM image of the sample in vertical cross-section, from which the effect of an electrochemical etch to produce a porous silicon region can be appreciated.
Figure 2b shows a photograph representation of an isolation layer between trenches which is approximately 20µm wide.
Figure 3 shows a TEM (Transmission Electron Microscopy) image of a porous silicon region as obtained by the method of this invention.

### Detailed Description

The process steps and the structures described hereinafter do not form an exhaustive process flow for manufacturing integrated circuits. This invention actually can be practised in combination with integrated circuit manufacturing techniques currently employed in the industry, and only such conventional commonly used process steps, necessary to understand the invention will be hereafter described.

Figures showing cross-sections through portions of an integrated circuit during its manufacture are not drawn to scale, but they rather highlight major features of the invention.

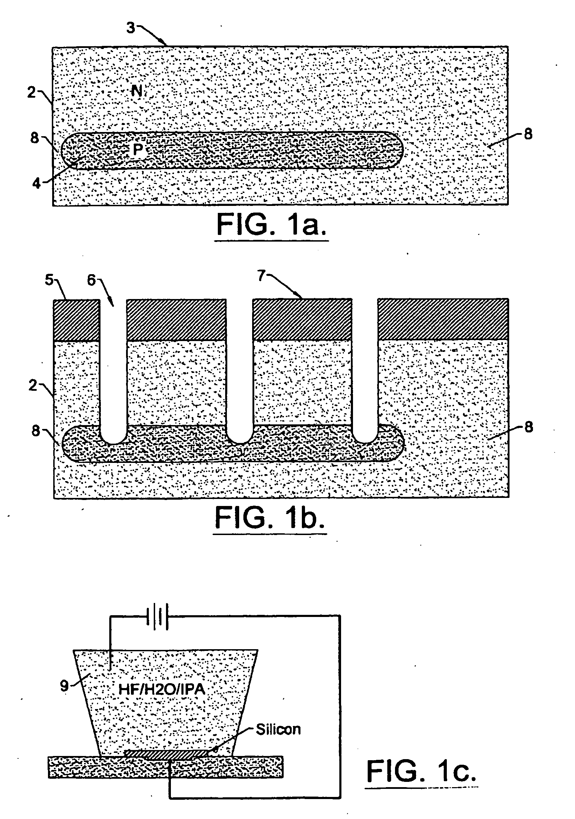

Referring to such figures, and especially to the example of Figure 1a, a substrate 2 of monocrystalline silicon, e.g. of the n type, is schematically shown at 1 which has a top surface 3 and includes a doped region 4, e.g. of the p type, buried in the substrate 2. The regions 8 represent doped regions adjacent to the buried region 4.

At location of selected areas, the substrate 2 is subjected to an etching step, for instance by an APCVD (Atmosphere Pression Chemical Vapor Deposition) process phase, which allows to define trench-like openings. In essence, an oxide 5 is first grown over the surface 3 of said substrate. Thereafter, the oxide 5 is etched away, using a mask, to form openings or trenches 6 which extend from the surface 7 of the oxide 5 down to the buried region 4, as illustrated in Figure 1b.

Following to the formation of the trenches 6, the oxide layer 5 is removed, and the structure visible in Figure 1b is subjected to electrochemical etching as shown in Figure 1c. This type of etch is applied in an electrochemical cell 9 containing a solution of water (H₂O) and hydrofluoric acid (HF). A solvent, such as isopropyl acid, can be added to this solution.

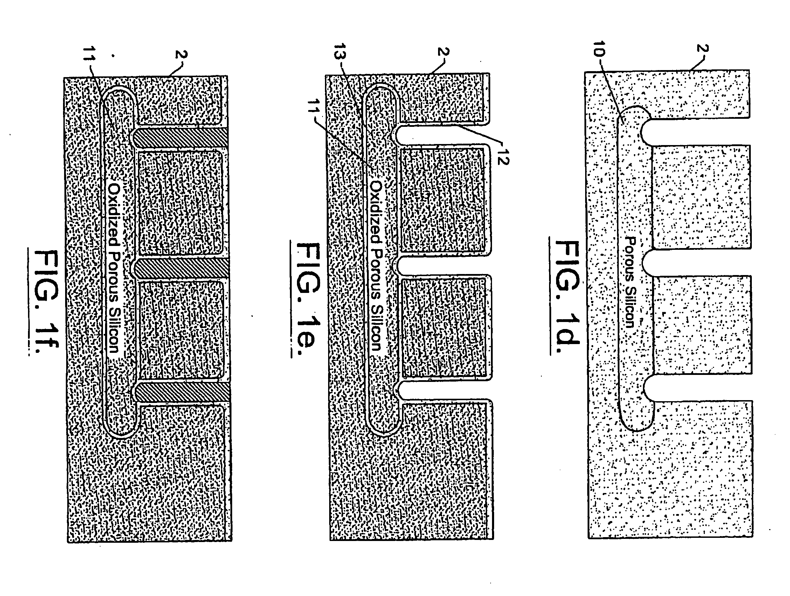

The semiconductor structure shown in Figure 1b is placed on the anode of the cell 9, at a positive potential as to the cell cathode. By utilising the difference of potential between the substrate 2 of monocrystalline silicon and the buried region 4, and suitably modulating the dopant distribution -- for example, the dopant concentration must be at least 10¹⁶ atoms/cm³ -- the doped buried region 4 is turned into a region 10 of porous silicon, obtaining a structure as shown in Figure 1d.

In addition, the electrochemical etching process has infinite selectivity, such as from 1 to 1000. In other words, the etch is only selective in the respect of the buried region 4. This is due to the fact that the electrochemical etch reactions cannot take place on the n-type region which, being at a lower potential than the p-type regions, acts as the cathode.

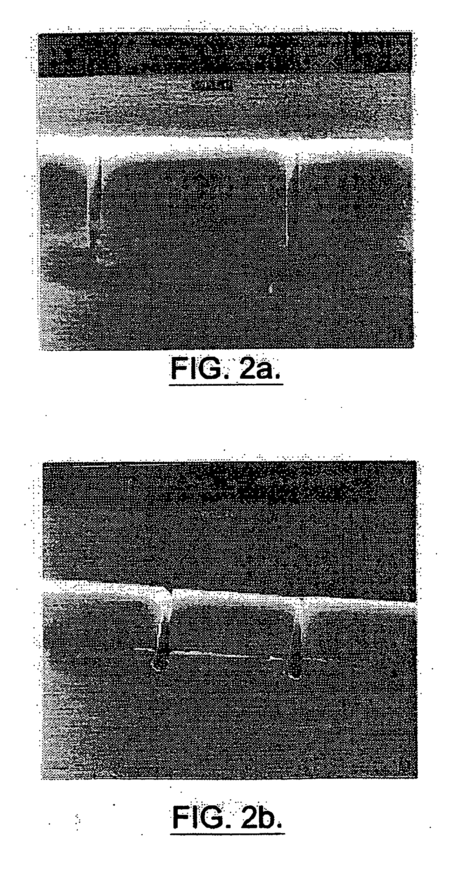

The porous silicon region extends all across the buried region. Accordingly, regions extending from one trench to an adjacent trench can be interconnected so that the buried doped region is formed without a continuing solution. The SEM image shown in Figure 2 illustrates the formation of the porous silicon.

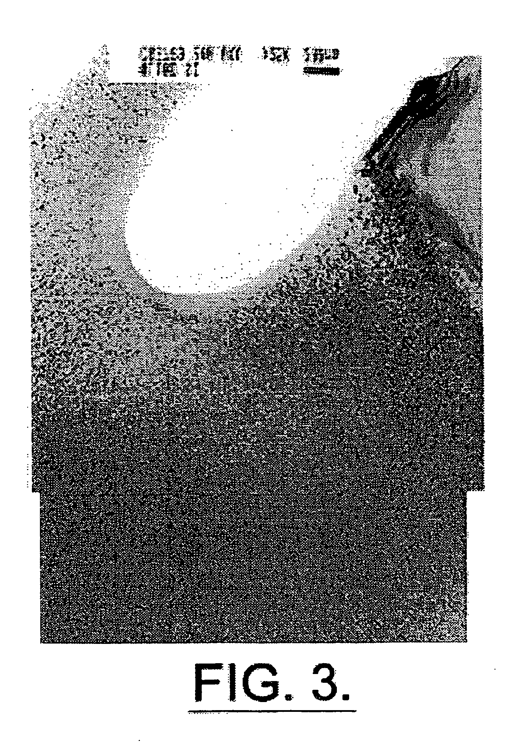

Subsequently, as shown in Figure 1e, the porous silicon region formed by electrochemical etching is converted to an oxide region 11. This conversion is obtained by an anodic oxidation within an electrolytic cell containing no HF. This oxidation step produces the oxidation of the porous silicon region, and causes a silicon oxide 12 grown also along the trench walls, as well as an oxide 13 grown at the interface between the region 11 of oxidised porous silicon and the region 2 of monocrystalline silicon. In this way, the structure shown in Figure le is obtained. The TEM vertical cross-section reproduced in Figure 3 shows that the whole buried region 4 has been oxidised, and that the SOI structure produced exhibits neither large defective regions nor regions of high stress.

Lastly, in a conventional way, a planarizing step is carried out on the SOI wafer to fill the trenches 6 with polysilicon (6), and an additional etching step is applied to the polysilicon itself, yielding the SOI wafer shown in Figure 1f.

Using the method described hereinabove, SOI wafers can be produced by comparable techniques to those of the standard process employed in the microelectronics industry and, therefore, at a much lower cost than by current SOI substrate manufacturing processes and with high levels of repeatability and reliability.

Standard electronic components can be fabricated inside and/or outside the monocrystalline silicon region overlying the region of oxidised porous silicon, in accordance with standard microelectronics techniques, or different (pressure, gas, temperature, etc.) sensors, microintegrated mechanical structures such as gyroscopes, micromotors, etc..

## Claims

1. A method of fabricating a SOI (Silicon-On-Insulator) wafer, suitable to manufacture electronic semiconductor devices and including a substrate of n type of monocrystalline silicon with a top surface, and a doped region of p type of monocrystalline silicon buried in said substrate, said doped buried region being trapped within the substrate of monocrystalline silicon; said method comprising:
- at least one step of forming trench-like openings extended from the substrate surface down to the buried region, said trench-like openings being not extended through all said doped buried region,
- a selective etching step carried out through said trench-like openings to change said buried region of p type of monocrystalline silicon into porous silicon, said selective etching step being an electrochemical etching process within an electrolytic cell and being selective only in the respect of the buried region of p type, said porous silicon region extending all across said doped buried region to form a continuous porous silicon region;
- a subsequent step of oxidising the buried region that has been changed into porous silicon, to obtain an insulating portion of said SOI wafer; said buried region oxidising step comprising on anodic oxidation within an electrolytic cell containing no hydrofluoric said (HF).

2. A method according to Claim 1, **characterised in that** said cell contains an aqueous solution of hydrofluoric acid (HF) and a solvent to promote the formation of said porous silicon.

3. A method according to Claims 2, **characterised in that** said wafer is placed on the anode of said electrolytic cell, at a positive potential as to the cathode of said electrolytic cell.

4. A method according to Claim 3, **characterised in that** said porous silicon is obtained by utilising the difference of potential between said substrate of monocrystalline silicon and said buried region, and by modulating the dopant distribution.

5. A method according to Claim 4, **characterised in that** the formation of porous silicon is initiated by only one of the trench-like openings and propagates towards the other trench-like openings.

6. A method according to Claim 5, **characterised in that** said etching process creates a smooth surface at the interface between the porous silicon and the monocrystalline silicon.

7. A method according to Claim 1, **characterised in that** said oxidising step produces the oxidation of the porous silicon and causes the grown of a silicon oxide along the walls of said trench-like openings as well as along the interface between the porous silicon and monocrystalline silicon.

8. A method according to Claim 1, **characterised in that** it comprises a subsequent step of planarizing the SOI wafer by filling the trench-like openings with polysilicon.

9. A method according to Claim 8, **characterised in that** it comprises an additional polysilicon etching step.

## Patentansprüche

1. Verfahren zum Herstellen eines SOI (Silizium-auf-Isolator-) Wafers, der für die Herstellung von elektronischen Halbleitervorrichtungen geeignet ist und der ein Substrat aus n-leitendem einkristallinem Silizium mit einer oberen Oberfläche sowie einen in dem Substrat versenkten dotierten Bereich aus p-leitendem einkristallinem Silizium aufweist, wobei der dotierte versenkte Bereich in dem Substrat aus einkristallinem Silizium eingeschlossen ist; wobei das Verfahren folgende Schritte aufweist:
- mindestens einen Schritt zum Bilden von grabenartigen Öffnungen, die sich von der Substratoberfläche bis zu dem versenkten Bereich nach unten erstrecken, wobei sich die grabenartigen Öffnungen nicht durch den gesamten dotierten versenkten Bereich hindurch erstrecken,
- einen selektiven Ätzschritt, der durch die grabenartigen Öffnungen hindurch ausgeführt wird, um den versenkten Bereich aus p-leitendem einkristallinem Silizium in poröses Silizium umzuwandeln, wobei es sich bei dem selektiven Ätzschritt um einen elektrochemischen Ätzvorgang innerhalb einer elektrolytischen Zelle handelt und dieser nur im Hinblick auf den versenkten p-leitenden Bereich selektiv ist, wobei sich der poröse Siliziumbereich über den gesamten dotierten versenkten Bereich erstreckt, um einen kontinuierlichen porösen Siliziumbereich zu bilden;
- einen anschließenden Schritt zum Oxidieren des versenkten Bereichs, der in poröses Silizium umgewandelt worden ist, um einen isolierenden Bereich des SOI-Wafers zu erhalten, wobei der Schritt zum Oxidieren des versenkten Bereichs eine anodische Oxidation innerhalb einer elektrolytischen Zelle aufweist, die keine Fluorwasserstoffsäure (HF) enthält.

2. Verfahren nach Anspruch 1,
**dadurch gekennzeichnet, dass** die Zelle eine wässrige Lösung aus Fluorwasserstoffsäure (HF) und ein Lösungsmittel zum Unterstützen der Bildung des porösen Siliziums enthält.

3. Verfahren nach Anspruch 2,
**dadurch gekennzeichnet, dass** der Wafer an der Anode der elektrolytischen Zelle auf einem positiven Potential gegenüber der Kathode der elektrolytischen Zelle platziert wird.

4. Verfahren nach Anspruch 3,
**dadurch gekennzeichnet, dass** das poröse Silizium unter Verwendung der Potentialdifferenz zwischen dem Substrat aus einkristallinem Silizium und dem versenkten Bereich sowie unter Anpassung der Dotierstoffverteilung erzielt wird.

5. Verfahren nach Anspruch 4,
**dadurch gekennzeichnet, dass** die Bildung des porösen Siliziums durch nur eine der grabenartigen Öffnungen initiiert wird und sich in Richtung auf die anderen grabenartigen Öffnungen fortpflanzt.

6. Verfahren nach Anspruch 5,
**dadurch gekennzeichnet, dass** der Ätzvorgang eine glatte Oberfläche an der Grenzfläche zwischen dem porösen Silizium und dem einkristallen Silizium erzeugt.

7. Verfahren nach Anspruch 1,
**dadurch gekennzeichnet, dass** der Oxidationsschritt die Oxidation des porösen Siliziums hervorruft und das Wachstum eines Siliziumoxids entlang der Wände der grabenartigen Öffnungen sowie entlang der Grenzfläche zwischen dem porösen Silizium und dem einkristallinen Silizium verursacht.

8. Verfahren nach Anspruch 1,
**dadurch gekennzeichnet, dass** es einen nachfolgenden Schritt des Einebnens des SOI-Wafers durch Füllen der grabenartigen Öffnungen mit Polysilizium aufweist.

9. Verfahren nach Anspruch 8,
**dadurch gekennzeichnet, dass** es einen zusätzlichen Polysilizium-Ätzschritt aufweist.

## Revendications

1. Procédé de fabrication d'une plaquette SOI (Silicium Sur Isolant), approprié pour fabriquer des dispositifs semiconducteurs électroniques et comprenant un substrat de type N en silicium monocristallin ayant une surface supérieure, et une région dopée de type P en silicium monocristallin enterrée dans le substrat, la région enterrée dopée étant piégée dans le substrat de silicium monocristallin ; le procédé comprenant :
au moins une étape de formation d'ouvertures en forme de tranchée s'étendant à partir de la surface du substrat vers le bas jusqu'à la région enterrée, les ouvertures en forme de tranchée ne s'étendant pas sur toute la région enterrée dopée,
une étape de gravure sélective réalisée sur les ouvertures en forme de tranchée pour transformer la région enterrée de type P, en silicium monocristallin, en silicium poreux, l'étape de gravure sélective étant un processus de gravure électrochimique dans une cellule électrolytique et étant sélective seulement en ce qui concerne la région enterrée de type P, la région de silicium poreux s'étendant sur toute la région enterrée dopée pour former une région de silicium poreux continue ;
une étape ultérieure d'oxydation de la région enterrée qui a été transformée en silicium poreux, pour obtenir une partie isolante de la plaquette SOI, l'étape d'oxydation de la région enterrée comprenant une oxydation anodique dans une cellule électrolytique ne contenant pas d'acide fluorhydrique (HF).

2. Procédé selon la revendication 1, **caractérisé en ce que** la cellule contient une solution aqueuse d'acide fluorhydrique (HF) et un solvant pour favoriser la formation du silicium poreux.

3. Procédé selon la revendication 2, **caractérisé en ce que** la plaquette est placée sur l'anode de la cellule électrolytique, à un potentiel positif par rapport à la cathode de la cellule électrolytique.

4. Procédé selon la revendication 3, **caractérisé en ce que** le silicium poreux est obtenu en utilisant la différence de potentiel entre le substrat en silicium monocristallin et la région enterrée, et en modulant la distribution de dopant.

5. Procédé selon la revendication 4, **caractérisé en ce que** la formation de silicium poreux est initiée par une seule des ouvertures en forme de tranchée et se propage vers les autres ouvertures en forme de tranchée.

6. Procédé selon la revendication 5, **caractérisé en ce que** le processus de gravure créé une surface lisse au niveau de l'interface entre le silicium poreux et le silicium monocristallin.

7. Procédé selon la revendication 1, **caractérisé en ce que** l'étape d'oxydation produit l'oxydation du silicium poreux et entraîne la croissance d'un oxyde de silicium le long des parois des ouvertures en forme de tranchée ainsi que le long de l'interface entre le silicium poreux et le silicium monocristallin.

8. Procédé selon la revendication 1, **caractérisé en ce qu'**il comprend une étape ultérieure consistant à planariser la plaquette SOI en remplissant les ouvertures en forme de tranchée avec du silicium polycristallin.

9. Procédé selon la revendication 8, **caractérisé en ce qu'**il comprend une étape supplémentaire de gravure de silicium polycristallin.
